# EUROPEAN PATENT APPLICATION

(11) **EP 4 629 753 A1**
(43) Date of publication of application: **08.10.2025**
(21) Application number: 23909326.3
(22) Date of filing: 08.09.2023
(51) Int. Cl.: H05K 1/02

(54) **FLEXIBLE CIRCUIT BOARD, DISPLAY MODULE, AND ELECTRONIC DEVICE**

(30) Priority: 30.12.2022 CN 202223600477 U
(71) Applicant: Honor Device Co., Ltd., Shenzhen, Guangdong 518040 (CN)
(72) Inventor: YIN, Ming, Shenzhen, Guangdong 518040 (CN)
(74) Representative: MERH-IP Matias Erny Reichl Hoffmann Patentanwälte PartG mbB
(86) International application number: PCT/CN2023/117672
(87) International publication number: WO 2024/139388

(57) **Abstract**

This application provides a flexible printed circuit, a display module, and an electronic device. The flexible printed circuit includes a substrate, a reference ground layer, and a signal layer. The substrate includes a first surface and a second surface that are disposed opposite to each other. The reference ground layer is disposed on the first surface of the substrate, and the reference ground layer includes a plurality of reference ground lines. The signal layer is disposed on the second surface of the substrate, the signal layer comprises a plurality of signal lines, the plurality of signal lines are disposed at intervals, and an orthographic projection of each signal line on the substrate is partially covered by orthographic projections of the plurality of reference ground lines on the substrate, or an orthographic projection of each signal line on the substrate is completely covered by an orthographic projection of one reference ground line on the substrate. The technical solutions of this application can optimize shielding performance of the flexible printed circuit while ensuring good operating performance of the flexible printed circuit.

## Description

This application claims priority to Chinese Patent Application No. 202223600477.2, filed with the China National Intellectual Property Administration on December 30, 2022 and entitled "FLEXIBLE PRINTED CIRCUIT, DISPLAY MODULE, AND ELECTRONIC DEVICE", which is incorporated herein by reference in its entirety.

### TECHNICAL FIELD

This application relates to the field of circuit board technologies, and in particular, to a flexible printed circuit, a display module, and an electronic device.

### BACKGROUND

In an electronic device, an interference problem means that a high-speed electronic component inside the device operates to generate high-frequency noise, and when the high-frequency noise falls into a communication frequency band, receiving sensitivity of the device is affected, resulting in deterioration of wireless performance. Currently, a flexible printed circuit in the electronic device is one of components that are most likely to cause the interference problem. How to achieve better shielding effectiveness of the flexible printed circuit based on satisfying operating performance of the flexible printed circuit is a topic continuously explored in the industry.

### SUMMARY

Embodiments of this application provide a flexible printed circuit, a display module, and an electronic device, to optimize shielding performance of the flexible printed circuit while ensuring good operating performance of the flexible printed circuit.

According to a first aspect, this application provides a flexible printed circuit. The flexible printed circuit includes:
a substrate, where the substrate includes a first surface and a second surface that are disposed opposite to each other;
a reference ground layer, where the reference ground layer is disposed on the first surface of the substrate, and the reference ground layer includes a plurality of reference ground lines; and
a signal layer, where the signal layer is disposed on the second surface of the substrate, the signal layer includes a plurality of signal lines, the plurality of signal lines are disposed at intervals, and an orthographic projection of each signal line on the substrate is partially covered by orthographic projections of the plurality of reference ground lines on the substrate, or an orthographic projection of each signal line on the substrate is completely covered by an orthographic projection of one reference ground line on the substrate.

Therefore, in a height direction of the flexible printed circuit, each signal line on the signal layer may have a specific overlapping part with the plurality of reference ground lines, so that a shielding effect of the reference ground layer is used, to achieve a noise shielding effect for the signal line on the signal layer. This has good reliability. Alternatively, in a height direction of the flexible printed circuit, each reference ground line can be disposed right above one or more signal lines, to achieve a good shielding effect on a part of the signal line that is most radiated. Therefore, without increasing costs and affecting flexibility and reliability of the flexible printed circuit, interference from the flexible printed circuit to the outside can be reduced, and wireless performance of an electronic device can be improved.

In a possible implementation, the plurality of reference ground lines are disposed in a cross manner to form a plurality of grids, a ratio of a width of the reference ground line to a width of the grid is 1:3, the width of the reference ground line is less than or equal to 0.1 mm, and the width of the grid is less than or equal to 0.3 mm.

It may be understood that, by way of setting the reference ground layer as a structure form of grid copper, a shielding function of the reference ground layer for the signal layer is implemented, so that the reference ground layer can have good flexibility, to adapt to a bending requirement of the flexible printed circuit. This has good reliability.

In a possible implementation, the plurality of reference ground lines are disposed in a cross manner to form a plurality of grids, a ratio of a width of the reference ground line to a width of the grid is 1:5, the width of the reference ground line is less than or equal to 0.1 mm, and the width of the grid is less than or equal to 0.5 mm.

It may be understood that, by way of setting the reference ground layer as a structure form of grid copper, a shielding function of the reference ground layer for the signal layer is implemented, so that the reference ground layer can have good flexibility, to adapt to a bending requirement of the flexible printed circuit. This has good reliability.

In a possible implementation, the plurality of reference ground lines are disposed at intervals along a length direction of the substrate, the plurality of signal lines are also arranged along the length direction of the substrate, and an orthographic projection of one reference ground line on the substrate covers orthographic projections of one or more signal lines on the substrate.

It may be understood that, in a height direction of the flexible printed circuit, each reference ground line can be disposed right above one or more signal lines, to achieve a good shielding effect on a part of the signal line that is most radiated. Therefore, without increasing costs and affecting flexibility and reliability of the flexible printed circuit, interference from the flexible printed circuit to the outside can be reduced, and wireless performance of an electronic device can be improved.

In a possible implementation, a distance between center lines of two adjacent reference ground lines is a first distance, a distance between center lines of two adjacent signal lines is a second distance, and the first distance is less than or equal to the second distance.

In this way, in a height direction of the flexible printed circuit, that the reference ground line can completely cover the signal line can be ensured, to further improve shielding performance of the reference ground layer.

In a possible implementation, a ratio of a width of the reference ground line to a width of the signal line is in a range of 1:2 to 5:1.

Under this setting, shielding performance may be achieved in a one-to-one correspondence manner in which, in the plurality of reference ground lines, one reference ground line corresponds to one signal line. Alternatively, shielding performance may be achieved in a many-to-one correspondence manner in which, in the plurality of reference ground lines, one reference ground line corresponds to a plurality of signal lines. This has good reliability.

In a possible implementation, the flexible printed circuit further includes a first shielding layer, and the first shielding layer is disposed on a side that is of the signal layer and that is away from the substrate.

It may be understood that, when a proportion of grid copper is large, shielding effectiveness of the reference ground layer may be reduced. To deal with a problem of insufficient electromagnetic compatibility caused by the reduced shielding effectiveness, a metal layer needs to be added on the outside of the signal layer and the reference ground layer to achieve shielding effectiveness. However, because the shielding effectiveness of the reference ground layer in this application is good, and is applicable to two cases: a large proportion of grid copper and a small proportion of grid copper, the reference ground layer may be replaced with a coating on a side of the reference ground layer during use, so that a metal shielding layer does not need to be disposed on the side of the reference ground layer, to achieve effects of reducing costs, a thickness, and a weight.

In a possible implementation, the flexible printed circuit further includes a first shielding layer and a second shielding layer. The first shielding layer is disposed on a side that is of the signal layer and that is away from the substrate, and the second shielding layer is disposed on a side that is of the reference ground layer and that is away from the substrate.

By way of disposing the first shielding layer and the second shielding layer, shielding performance of the flexible printed circuit can be further improved. This has good reliability.

According to a second aspect, this application further provides a display module. The display module includes a display and the foregoing flexible printed circuit, and the flexible printed circuit is electrically connected to the display.

According to a third aspect, this application further provides an electronic device. The electronic device includes the foregoing display module.

### BRIEF DESCRIPTION OF DRAWINGS

FIG. 1 is a diagram of a structure of an electronic device according to an embodiment of this application;
FIG. 2 is a schematic cross-sectional view obtained through cutting along a cutting line A-A shown in FIG. 1;
FIG. 3 is a diagram of a structure of a flexible printed circuit shown in FIG. 2;
FIG. 4 is a schematic top view of a signal layer of a substrate shown in FIG. 3;
FIG. 5 is a diagram of a structure of a reference ground layer using solid copper in a conventional technology;
FIG. 6 is a diagram of magnetic field distribution of the solid copper shown in FIG. 5;
FIG. 7 is a diagram of a structure of a reference ground layer using grid copper in a conventional technology;
FIG. 8 is a diagram of magnetic field distribution of the grid copper shown in FIG. 7;
FIG. 9 is a schematic top view of a first embodiment of a reference ground layer of a substrate shown in FIG. 3;
FIG. 10 is another schematic top view of a first embodiment of a reference ground layer of a substrate shown in FIG. 3;
FIG. 11 is still another schematic top view of a first embodiment of a reference ground layer of a substrate shown in FIG. 3;
FIG. 12 is a diagram of electric field distribution of the reference ground layer shown in FIG. 9;
FIG. 13 is a diagram of electric field distribution of the reference ground layer shown in FIG. 10;
FIG. 14 is a diagram of electric field distribution of the reference ground layer shown in FIG. 11;
FIG. 15 is a diagram of magnetic field distribution of the reference ground layer shown in FIG. 9;
FIG. 16 is a diagram of magnetic field distribution of the reference ground layer shown in FIG. 10;
FIG. 17 is a diagram of magnetic field distribution of the reference ground layer shown in FIG. 11;
FIG. 18 is a diagram of a relative positional relationship between the reference ground layer shown and a signal layer in FIG. 9;
FIG. 19 is a schematic top view of a second embodiment of a reference ground layer of a substrate shown in FIG. 3;
FIG. 20 is a diagram of a relative positional relationship between the reference ground layer and a signal layer shown in FIG. 19;
FIG. 21 is a diagram of an electric field vector between the reference ground layer and a signal layer shown in FIG. 19;
FIG. 22 is a diagram of a magnetic field vector between the reference ground layer and a signal layer shown in FIG. 19;
FIG. 23 is a diagram of electric field distribution of the reference ground layer shown in FIG. 19;
FIG. 24 is a diagram of magnetic field distribution of the reference ground layer shown in FIG. 19;
FIG. 25 is a diagram of another structure of a flexible printed circuit shown in FIG. 2; and
FIG. 26 is a diagram of still another structure of a flexible printed circuit shown in FIG. 2.

### DESCRIPTION OF EMBODIMENTS

For ease of understanding, terms in embodiments of this application are first explained.

A term "and/or" describes only an association relationship for describing associated objects and represents that three relationships may exist. For example, A and/or B may represent the following three cases: only A exists, both A and B exist, and only B exists.

A term "a plurality of" means two or more.

A term "connection" should be understood in a broad sense. For example, a connection between A and B may be a direct connection between A and B, or an indirect connection between A and B by using an intermediary.

The following clearly describes specific implementations of this application with reference to the accompanying drawings.

Embodiments of this application provide a flexible printed circuit, a display module, and an electronic device.

The electronic device may be, but not limited to, a smart consumer electronic device such as a mobile phone, a tablet computer, or a notebook computer; or a wearable electronic device such as an augmented reality (augmented reality, AR) device, a virtual reality (virtual reality, VR) device, a smart watch, or a smartband; or a vehicle-mounted device such as a car computer.

A description is provided below by using an example in which the electronic device is a mobile phone, but it should be understood that this application is not limited thereto.

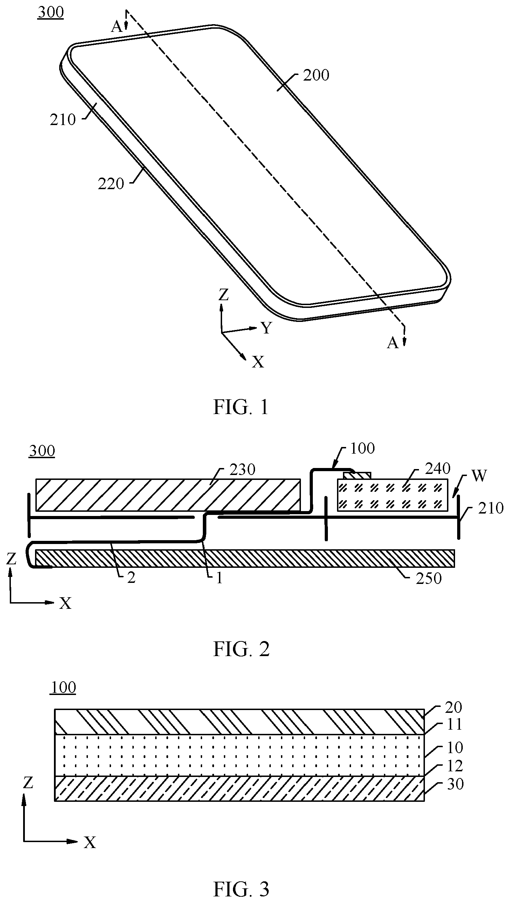

Refer to FIG. 1 and FIG. 2. FIG. 1 is a diagram of a structure of an electronic device 300 according to an embodiment of this application, and FIG. 2 is a schematic cross-sectional view obtained through cutting along a cutting line A-A shown in FIG. 1.

In embodiments of this application, for ease of illustration, a length direction of the electronic device 300 is defined as a first direction X, a width direction of the electronic device 300 is defined as a second direction Y, a height direction of the electronic device 300 is defined as a third direction Z, and the first direction X, the second direction Y, and the third direction Z are perpendicular to each other.

The electronic device 300 may include a display module 200, a frame 210, a rear cover 220, a battery 230, and a circuit board 240. The display module 200 is configured to display text, an image, a video, and the like. The frame 210 is used as a structural bearing component of the electronic device 300, and is configured to install other components such as the display module 200 and the rear cover 220. The display module 200 and the rear cover 220 are respectively connected to two opposite sides of the frame 210. When the electronic device 300 is a mobile phone, the frame 210 is a middle frame of the mobile phone, and the display module 200 is a cover that faces a face of a user when the user holds the mobile phone. A display may be disposed to present visual information such as an image, a color, and text. The rear cover 220 is a cover that faces away from the face of the user when the user holds the mobile phone, and a camera module may be disposed as a rear camera to capture a static image or a dynamic video at the rear of the mobile phone. For example, a material of the rear cover 220 includes glass, plastic, or ceramics.

The display module 200, the rear cover 220, and the frame 210 cooperatively enclose to form an accommodating space W of the electronic device 300. As shown in FIG. 1 and FIG. 2, the circuit board 240 and the battery 230 are located in the accommodating space W, and the circuit board 240 and the battery 230 are located between the frame 210 and the rear cover 220. The display module 200 may include a flexible printed circuit (Flexible Printed Circuit, FPC) 100 and a display 250. The flexible printed circuit 100 may include a plurality of bending parts 1 and a plurality of non-bending parts 2. The bending part 1 can be bent relative to the non-bending part 2, so that the flexible printed circuit 100 entirely presents a bent and extended structural form. One end of the flexible printed circuit 100 may be electrically connected to the display 250, and the other end of the flexible printed circuit 100 may be electrically connected to a component on the circuit board 240 through the frame 210, to implement a control function of the circuit board 240 for the display 250.

It may be understood that, in the electronic device 300, an interference problem means that a high-speed electronic component inside the device operates to generate high-frequency noise, and when the high-frequency noise falls into a communication frequency band, receiving sensitivity of the device is affected, resulting in deterioration of wireless performance. Currently, in the electronic device 300, because the display 250 in the display module 200 has a high refresh rate and a large area, and wiring of the flexible printed circuit 100 is long, the display module 200 is one of modules most likely to cause the interference problem. Therefore, embodiments of this application can provide a flexible printed circuit 100, and can optimize shielding performance of the flexible printed circuit 100 while ensuring good operating performance of the flexible printed circuit 100. Details are described below.

Refer to FIG. 3. FIG. 3 is a diagram of a structure of the flexible printed circuit 100 shown in FIG. 2. The flexible printed circuit 100 may include a substrate 10, a reference ground layer 20, and a signal layer 30. For example, the substrate 10 may be a flexible substrate. The signal layer 30 may be a signal layer including an MIPI (Mobile Industry Processor Interface, mobile industry processor interface) differential line. The reference ground layer 20 may be a reference ground layer of the MIPI differential line, and the reference ground layer 20 may provide a shielding effect for high-frequency noise on the MIPI differential line.

The substrate 10 includes a first surface 11 and a second surface 12 that are disposed opposite to each other. The reference ground layer 20 is disposed on the first surface 11 of the substrate 10, and the signal layer 30 is disposed on the second surface 12 of the substrate 10. To be specific, the reference ground layer 20 and the signal layer 30 are respectively disposed on opposite sides of the substrate 10, and the substrate 10, the reference ground layer 20, and the signal layer 30 may jointly form a bending part 1 and a non-bending part 2 of the circuit board 240.

It should be noted that, the following improvements in the structure of each layer of the flexible printed circuit 100 may be applied to the bending part 1 and the non-bending part 2 of the flexible printed circuit 100 without conflict. This is not strictly limited in embodiments of this application.

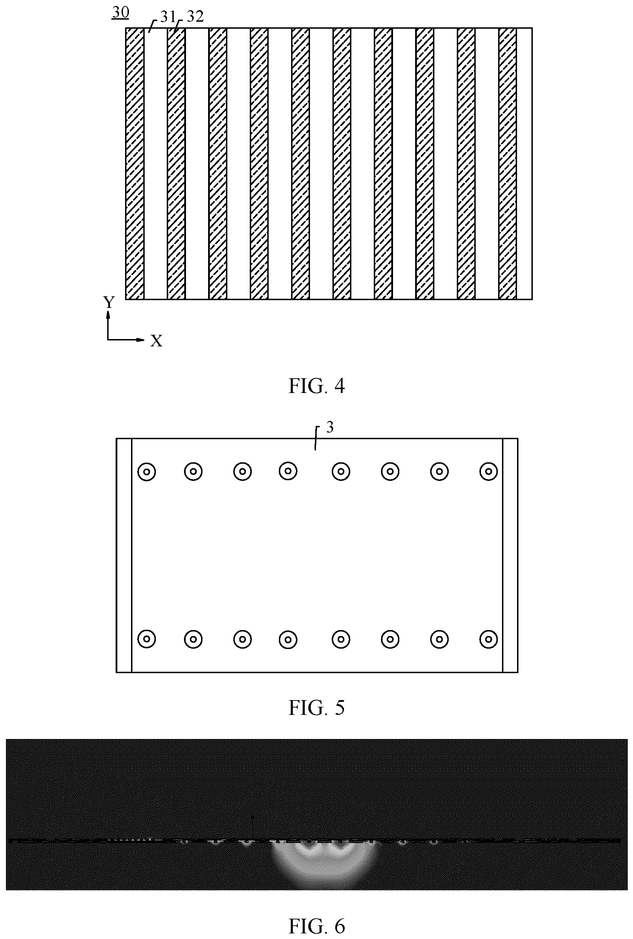

Refer to FIG. 4. FIG. 4 is a schematic top view of the signal layer 30 of the substrate 10 shown in FIG. 3. The signal layer 30 may include a plurality of signal lines 31 and a plurality of ground lines 32. The signal lines 31 are used for implementing a signal transmission function of the flexible printed circuit 100, and the ground lines 32 are used for implementing functions of grounding and spacing the signal lines 31. The plurality of signal lines 31 are disposed at intervals along a length direction (that is, the first direction X) of the substrate 10. A gap region between two adjacent signal lines 31 is used for accommodating one ground line 32. To be specific, the plurality of signal lines 31 disposed at intervals can form a plurality of gap regions, and the plurality of ground lines 32 are sequentially arranged and disposed in the plurality of gap regions. For example, materials of the signal line 31 and the ground line 32 may be copper.

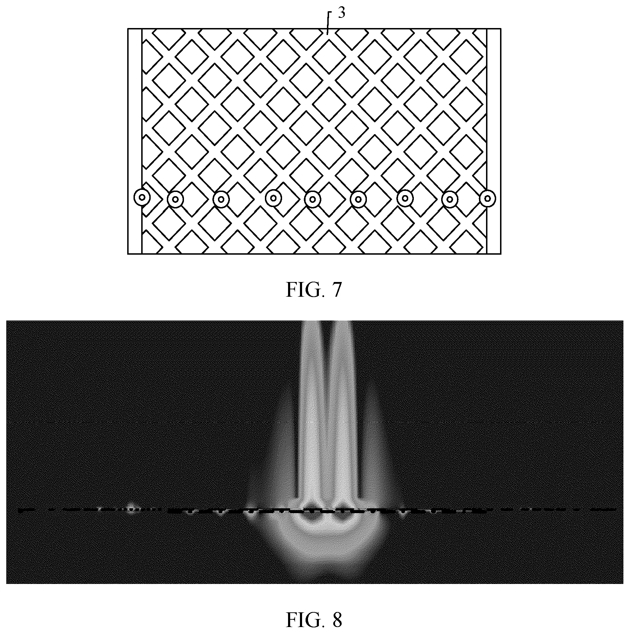

Refer to FIG. 5, FIG. 6, FIG. 7, and FIG. 8. FIG. 5 is a diagram of a structure of a reference ground layer 3 using solid copper in a conventional technology, FIG. 6 is a diagram of magnetic field distribution of the solid copper shown in FIG. 5, FIG. 7 is a diagram of a structure of the reference ground layer 3 using grid copper in the conventional technology, and FIG. 8 is a diagram of magnetic field distribution of the grid copper shown in FIG. 7.

In the conventional technology, as shown in FIG. 5 and FIG. 6, a noise shielding effect for the signal layer is good when the solid copper is used for the reference ground layer 3. However, in an actual use process of the FPC, considering that the FPC needs to be bent in some regions, in consideration of flexibility, a proportion of the copper in the reference ground layer 3 needs to be reduced. As shown in FIG. 7 and FIG. 8, a final current situation is that the reference ground 3 of the FPC uses a grid-shaped reference ground design, commonly referred to as "grid copper". A ratio of a line width to a gap is referred to as a grid copper ratio. It can be known based on a shielding principle that, this indicates better shielding effectiveness when a smaller proportion of grid copper is closer to solid copper.

However, the reference ground layer 20 provided in embodiments of this application has a more excellent shielding effect than grid copper in the conventional technology. The following describes a structure of the reference ground layer 20 in detail by using two specific embodiments.

### First embodiment:

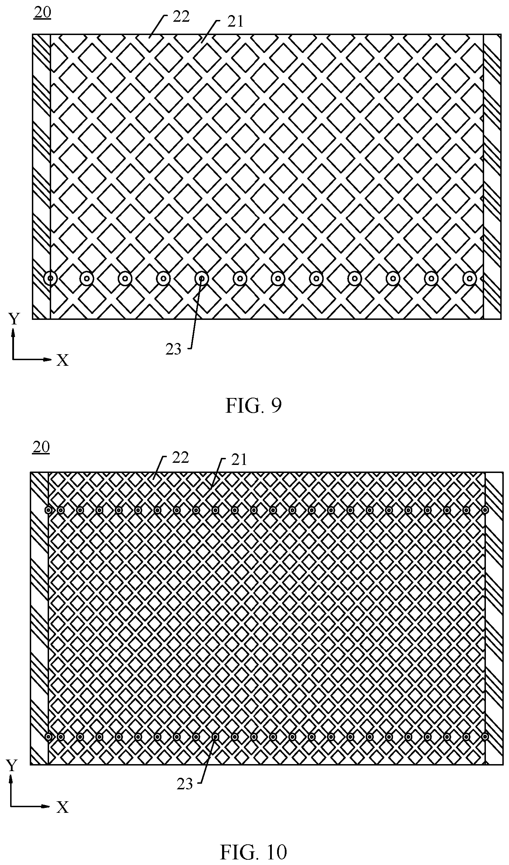

Refer to FIG. 9. FIG. 9 is a schematic top view of the first embodiment of the reference ground layer 20 of the substrate 10 shown in FIG. 3. The reference ground layer 20 may include a plurality of reference ground lines 21, each reference ground line 21 is disposed obliquely to the first direction X. The plurality of reference ground lines 21 is disposed in a cross manner to form a plurality of grids 22. An intersection angle between two adjacent reference ground lines 21 may be selected based on an actual application requirement of the reference ground layer 20, and may be any angle such as 30° or 45°. The intersection angle between two adjacent reference ground lines 21 is not strictly limited in this embodiment. For example, a material of the reference ground line 21 may be copper.

It may be understood that, by way of setting the reference ground layer 20 as a structure form of grid copper, a shielding function of the reference ground layer 20 for the signal layer 30 is implemented, so that the reference ground layer 20 can have good flexibility, to adapt to a bending requirement of the flexible printed circuit 100. This has good reliability.

The reference ground layer 20 may further include a plurality of ground points 23, the plurality of ground points 23 are distributed at intervals on the plurality of reference ground lines 21, and the plurality of ground points 23 are used to be electrically connected to a ground line 32 of the signal layer 30.

In a possible implementation, a ratio of a width of the reference ground line 21 to a width of the grid 22 may be 1:3, the width of the reference ground line 21 is less than or equal to 0.1 mm, and the width of the grid 22 is less than or equal to 0.3 mm.

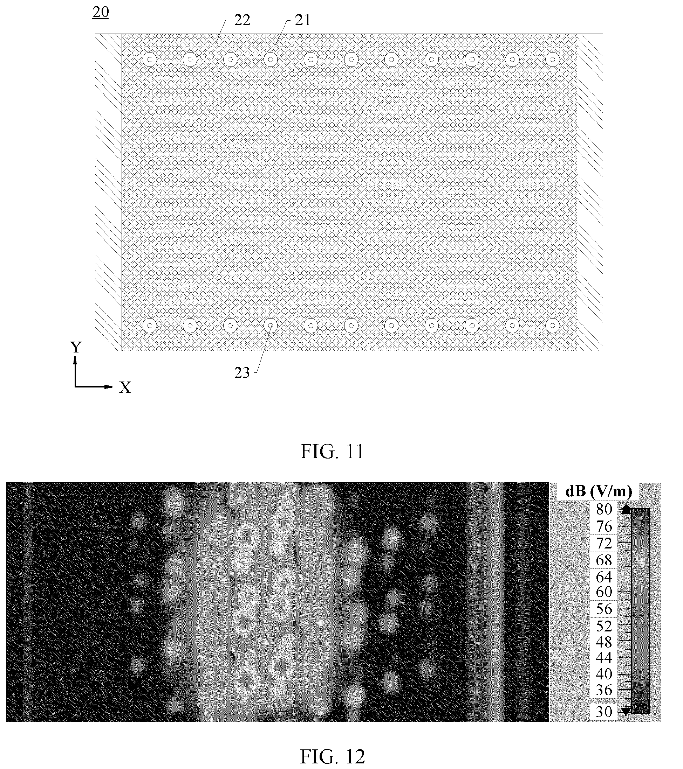

For example, refer to FIG. 9, FIG. 10, and FIG. 11. FIG. 10 is another schematic top view of the first embodiment of the reference ground layer 20 of the substrate 10 shown in FIG. 3, and FIG. 11 is still another schematic top view of the first embodiment of the reference ground layer 20 of the substrate 10 shown in FIG. 3.

As shown in FIG. 9, the line width of the reference ground line 21 is 0.1 mm, and the width of the grid 22 is 0.3 mm. As shown in FIG. 10, the line width of the reference ground line 21 is 0.05 mm, and the width of the grid 22 is 0.15 mm. As shown in FIG. 11, the line width of the reference ground line 21 is 0.02 mm, and the width of the grid 22 is 0.06 mm. To be specific, the line width of the reference ground line 21 shown in FIG. 10 is a half of the line width of the reference ground line 21 shown in FIG. 9, and the line width of the reference ground line 21 shown in FIG. 11 is a fifth of the line width of the reference ground line 21 shown in FIG. 9.

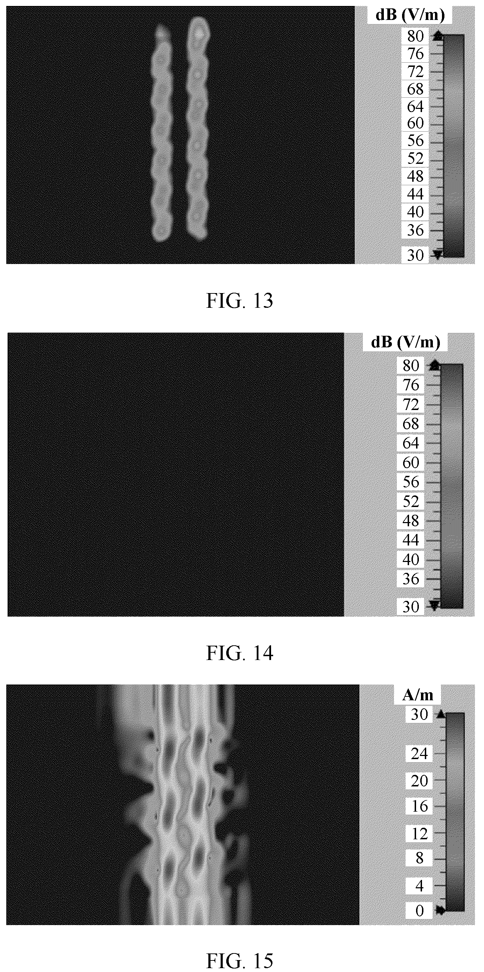

Refer to FIG. 12, FIG. 13, and FIG. 14. FIG. 12 is a diagram of electric field distribution of the reference ground layer 20 shown in FIG. 9, FIG. 13 is a diagram of electric field distribution of the reference ground layer 20 shown in FIG. 10, and FIG. 14 is a diagram of electric field distribution of the reference ground layer 20 shown in FIG. 11. It can be seen that, when the line width of the reference ground line 21 is reduced to a half, a radiated electric field strength is reduced by 20 dB. When the line width of the reference ground line 21 is reduced to one fifth, the radiated electric field strength is reduced by 40 dB.

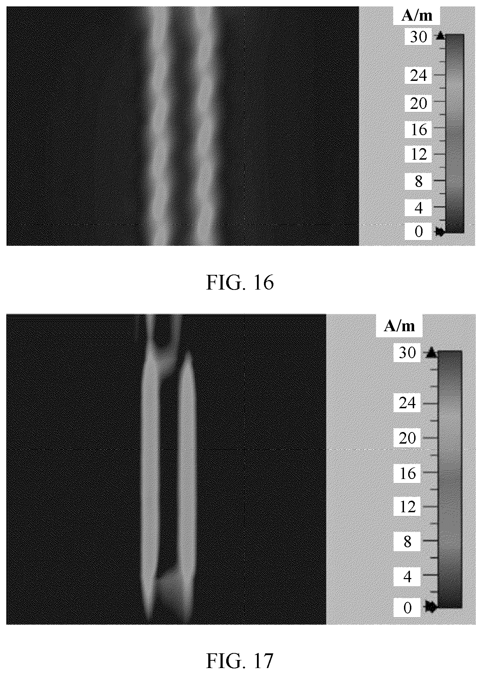

Refer to FIG. 15, FIG. 16, and FIG. 17. FIG. 15 is a diagram of magnetic field distribution of the reference ground layer 20 shown in FIG. 9, FIG. 16 is a diagram of magnetic field distribution of the reference ground layer 20 shown in FIG. 10, and FIG. 17 is a diagram of magnetic field distribution of the reference ground layer 20 shown in FIG. 11.

It can be seen that, when the line width of the reference ground line 21 is reduced to a half, the radiated magnetic field strength is reduced. When the line width of the reference ground line 21 is reduced to one fifth, the radiated magnetic field strength is further reduced.

Based on the foregoing descriptions, it should be understood that, when a proportion of grid copper is the same, the line width of the reference ground line 21 may be adjusted to make the line width of the reference ground line 21 be finer, so that the grids 22 formed by crossing the reference ground lines 21 are arranged more densely in a same board area, to achieve a better shielding effect. Therefore, without increasing costs and affecting flexibility and reliability of the flexible printed circuit 100, interference from the flexible printed circuit 100 to the outside can be reduced, and wireless performance of the electronic device 300 can be improved.

In another possible implementation, a ratio of the width of the reference ground line 21 to the width of the grid 22 may be 1:5, the width of the reference ground line 21 is less than or equal to 0.1 mm, and the width of the grid 22 is less than or equal to 0.5 mm.

It should be noted that, the ratio of the width of the reference ground line 21 to the width of the grid 22 is not limited to the foregoing listed examples. A ratio that can achieve greater distribution density with a same board area all fall within the protection scope of embodiments of this application, and this is not strictly limited thereto.

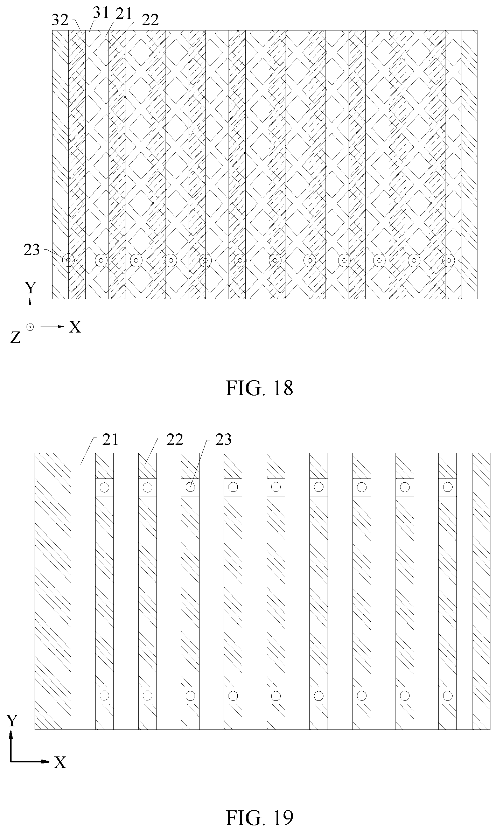

Refer to FIG. 18. FIG. 18 is a diagram of a relative positional relationship between the reference ground layer 20 and the signal layer 30 shown in FIG. 9. It can be seen that, in the third direction Z, each signal line 31 on the signal layer 30 is partially covered by the plurality of reference ground lines 21, and a part that is in each signal line 31 and that is not covered by the reference ground line 21 is exposed through the grid 22. To be specific, an orthographic projection of each signal line 31 on the signal layer 30 on the substrate 10 is partially covered by orthographic projections of the plurality of reference ground lines 21 on the substrate 10.

Therefore, in a height direction of the flexible printed circuit 100, each signal line 31 on the signal layer 30 has a specific overlapping part with the plurality of reference ground lines 21, so that a shielding effect of the reference ground layer 20 is used, to achieve a noise shielding effect for the signal line 31 on the signal layer 30. This has good reliability.

### Second embodiment:

Refer to FIG. 19. FIG. 19 is a schematic top view of the second embodiment of the reference ground layer 20 of the substrate 10 shown in FIG. 3. In this embodiment, content the same as that in the first embodiment is not described again, and a difference from the first embodiment lies in that the plurality of reference ground lines 21 are disposed at intervals along the length direction (that is, the first direction X) of the substrate 10. Under this setting, the plurality of reference ground lines 21 are distributed in a grating-type grid ground.

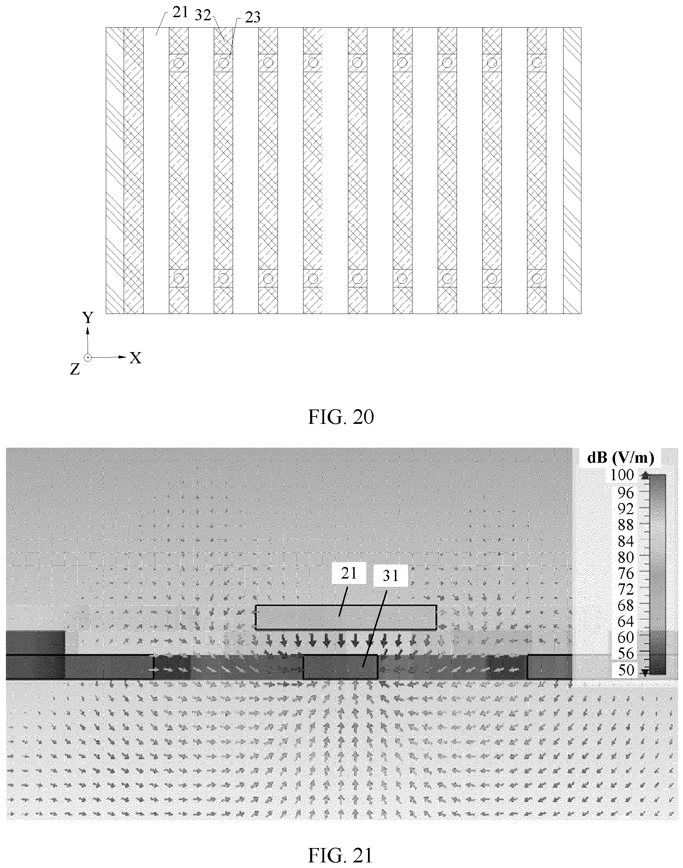

Refer to FIG. 20. FIG. 20 is a diagram of a relative positional relationship between the reference ground layer 20 and the signal layer 30 shown in FIG. 19. It can be seen that, in the third direction Z, each signal line 31 on the signal layer 30 is entirely covered by one reference ground line 21. To be specific, an orthographic projection of each signal line 31 on the signal layer 30 on the substrate 10 is completely covered by an orthographic projection of one reference ground line 21 on the substrate 10.

It may be understood that, an orthographic projection of one reference ground line 21 on the substrate 10 covers orthographic projections of one or more signal lines 21 on the substrate 10. To be specific, in the height direction of the flexible printed circuit 100, each reference ground line 21 can be disposed right above one or more signal lines 31, to achieve a good shielding effect on a part of the signal line 31 that is most radiated. Therefore, without increasing costs and affecting flexibility and reliability of the flexible printed circuit 100, interference from the flexible printed circuit 100 to the outside can be reduced, and wireless performance of the electronic device 300 can be improved.

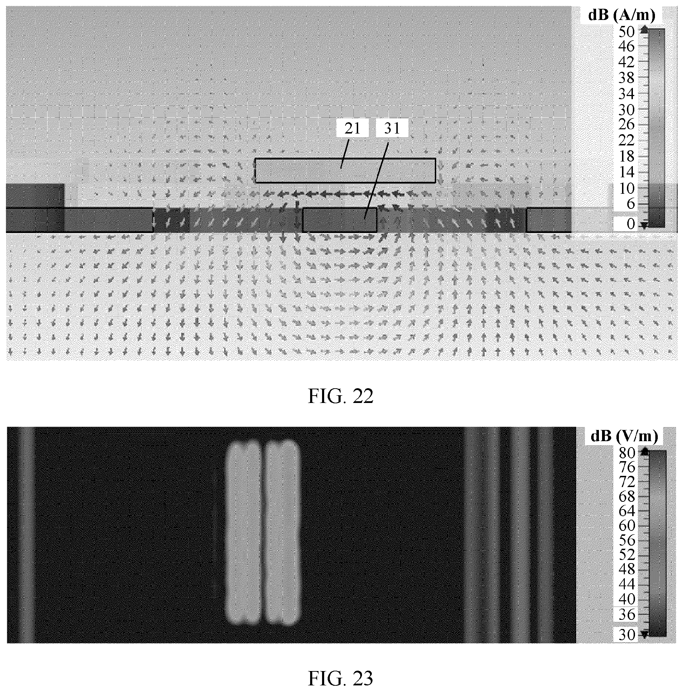

Specifically, refer to FIG. 21 and FIG. 22. FIG. 21 is a diagram of an electric field vector between the reference ground layer 20 and the signal layer 30 shown in FIG. 19, and FIG. 22 is a diagram of a magnetic field vector between the reference ground layer 20 and the signal layer 30 shown in FIG. 19. It may be understood that because the grating-type reference ground line 21 is disposed right above the signal line 31, and the reference ground line 21 is a metal line, a skin effect of metal enables a region of a strongest electromagnetic field around the signal line 31 not directly to radiate to the outside. However, when the electromagnetic field wraps around two sides of the reference ground line 21 and has a condition of radiating to the outside, a radiation strength is significantly reduced, to achieve a good shielding effect.

Refer to FIG. 12, FIG. 15, and FIG. 23. FIG. 23 is a diagram of electric field distribution of the reference ground layer 20 shown in FIG. 19. It can be seen that, after the reference ground layer 20 is replaced from a grid-shaped structure to a grating-type structure, an externally radiated electric field effect of the flexible printed circuit 100 is reduced by 30 dB.

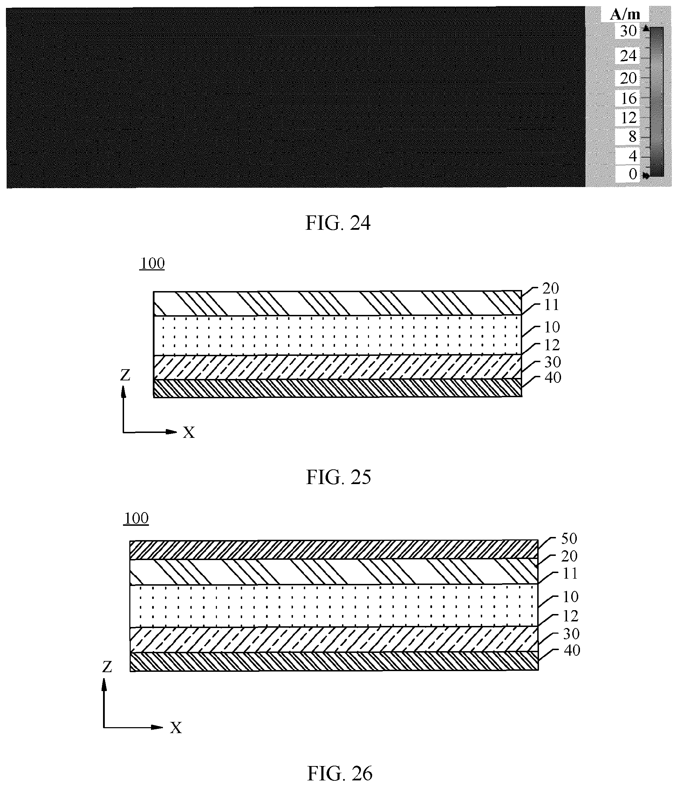

Refer to FIG. 13, FIG. 16, and FIG. 24. FIG. 24 is a diagram of magnetic field distribution of the reference ground layer 20 shown in FIG. 19.

It can be seen that, after the reference ground layer 20 is replaced from a grid-shaped structure to a grating-type structure, an externally radiated electric field effect of the flexible printed circuit 100 is reduced.

Based on the foregoing descriptions, it should be understood that, in a same grid ground proportion, the grating-type structure is used to replace the grid structure, to achieve a stronger shielding effect. In addition, the grating-type structure is simple, and helps reduce production costs of the flexible printed circuit 100.

In a possible implementation, a ratio of the width of the reference ground line 21 to a distance between two adjacent reference ground lines 21 may be 1:3, the width of the reference ground line 21 is less than or equal to 0.1 mm, and the distance between two adjacent reference ground lines 21 is less than or equal to 0.3 mm.

In another possible implementation, a ratio of the width of the reference ground line 21 to a distance between two adjacent reference ground lines 21 may be 1:5, the width of the reference ground line 21 is less than or equal to 0.1 mm, and the distance between two adjacent reference ground lines 21 is less than or equal to 0.5 mm.

It should be noted that, the ratio of the width of the reference ground line 21 to the two adjacent reference ground lines 21 is not limited to the foregoing listed examples. A ratio that can achieve greater distribution density with a same board area all fall within the protection scope of embodiments of this application, and this is not strictly limited thereto.

In this embodiment, a distance between center lines of two adjacent reference ground lines 21 is a first distance, a distance between center lines of two adjacent signal lines 31 is a second distance, and the first distance may be less than or equal to the second distance. Therefore, it can be ensured that the reference ground line 21 can completely cover the signal line 31 in the height direction of the flexible printed circuit 100, to further improve shielding performance of the reference ground layer 20.

For example, a ratio of the width of the reference ground line 21 to a width of the signal line 31 may be in a range of 1:2 to 5:1 (including endpoint values: 1:2 and 5:1). Under this setting, shielding performance may be achieved in a one-to-one correspondence manner in which, in the plurality of reference ground lines 21, one reference ground line 21 corresponds to one signal line 31. Alternatively, shielding performance may be achieved in a many-to-one correspondence manner in which, in the plurality of reference ground lines 21, one reference ground line 21 corresponds to a plurality of signal lines 31. This has good reliability.

In this embodiment of this application, by way of using the reference ground layer 20 described in the foregoing two embodiments, when the proportion of the grid copper is used the same as that in the conventional technology, in a plurality of manners, for example, by way of improving layout density of the grid copper in Embodiment 1 and/or by way of covering the signal line 31 by using in a grating-type grid ground in Embodiment 2, interference from the flexible printed circuit 100 to the outside is reduced, and electromagnetic shielding performance of the flexible printed circuit 100 is improved.

It should be noted that, the following improvements in the structure of the reference ground layer 20 in the flexible printed circuit 100 may also be applied to a radio frequency transmission line. This is not strictly limited in embodiments of this application.

In a possible implementation, refer to FIG. 25. FIG. 25 is a diagram of another structure of the flexible printed circuit 100 shown in FIG. 2. The flexible printed circuit 100 may further include a first shielding layer 40. The first shielding layer 40 is disposed on a side that is of the signal layer 30 and that is away from the substrate 10. A material of the first shielding layer 40 is metal.

It may be understood that, when a proportion of grid copper is large, shielding effectiveness of the reference ground layer 20 may be reduced. To deal with a problem of insufficient electromagnetic compatibility caused by the reduced shielding effectiveness, a metal layer needs to be added on the outside of the signal layer 30 and the reference ground layer 20 to achieve shielding effectiveness. However, because the shielding effectiveness of the reference ground layer 20 in this application is good, and is applicable to two cases: a large proportion of grid copper and a small proportion of grid copper, the reference ground layer may be replaced with a coating on a side of the reference ground 20 layer during use, so that a metal shielding layer does not need to be disposed on the side of the reference ground layer 20, to achieve effects of reducing costs, a thickness, and a weight.

In another possible implementation, refer to FIG. 26. FIG. 26 is a diagram of still another structure of the flexible printed circuit 100 shown in FIG. 2. The flexible printed circuit 100 may further include a first shielding layer 40 and a second shielding layer 50. The first shielding layer 40 is disposed on a side that is of the signal layer 30 and that is away from the substrate 10, and the second shielding layer 50 is disposed on a side that is of the reference ground layer 20 and that is away from the substrate 10. Materials of the first shielding layer 40 and the second shielding layer 50 are metal. By way of disposing the first shielding layer 40 and the second shielding layer 50, shielding performance of the flexible printed circuit 100 can be further improved. This has good reliability.

Embodiments of this application are described above in detail. The principles and implementations of this application are described by using specific examples in this specification, and the foregoing descriptions about embodiments are merely intended to help understand the method and the core idea of the method of this application. Meanwhile, a person of ordinary skill in the art may make modifications to the specific implementations and application scope according to the idea of this application. In conclusion, the content of this specification shall not be understood as a limitation on this application.

## Claims

1. A flexible printed circuit, wherein the flexible printed circuit comprises:
a substrate, wherein the substrate comprises a first surface and a second surface that are disposed opposite to each other;
a reference ground layer, wherein the reference ground layer is disposed on the first surface of the substrate, and the reference ground layer comprises a plurality of reference ground lines; and
a signal layer, wherein the signal layer is disposed on the second surface of the substrate, the signal layer comprises a plurality of signal lines, the plurality of signal lines are disposed at intervals, and an orthographic projection of each signal line on the substrate is partially covered by orthographic projections of the plurality of reference ground lines on the substrate, or an orthographic projection of each signal line on the substrate is completely covered by an orthographic projection of one reference ground line on the substrate.

2. The flexible printed circuit according to claim 1, wherein the plurality of reference ground lines are disposed in a cross manner to form a plurality of grids, a ratio of a width of the reference ground line to a width of the grid is 1:3, the width of the reference ground line is less than or equal to 0.1 mm, and the width of the grid is less than or equal to 0.3 mm.

3. The flexible printed circuit according to claim 1, wherein the plurality of reference ground lines are disposed in a cross manner to form a plurality of grids, a ratio of a width of the reference ground line to a width of the grid is 1:5, the width of the reference ground line is less than or equal to 0.1 mm, and the width of the grid is less than or equal to 0.5 mm.

4. The flexible printed circuit according to claim 1, wherein the plurality of reference ground lines are disposed at intervals along a length direction of the substrate, the plurality of signal lines are also arranged along the length direction of the substrate, and an orthographic projection of one reference ground line on the substrate covers orthographic projections of one or more signal lines on the substrate.

5. The flexible printed circuit according to claim 4, wherein a distance between center lines of two adjacent reference ground lines is a first distance, a distance between center lines of two adjacent signal lines is a second distance, and the first distance is less than or equal to the second distance.

6. The flexible printed circuit according to claim 4, wherein a ratio of a width of the reference ground line to a width of the signal line is in a range of 1:2 to 5:1.

7. The flexible printed circuit according to any one of claims 1 to 6, wherein the flexible printed circuit further comprises a first shielding layer, and the first shielding layer is disposed on a side that is of the signal layer and that is away from the substrate.

8. The flexible printed circuit according to any one of claims 1 to 6, wherein the flexible printed circuit further comprises a first shielding layer and a second shielding layer, the first shielding layer is disposed on a side that is of the signal layer and that is away from the substrate, and the second shielding layer is disposed on a side that is of the reference ground layer and that is away from the substrate.

9. A display module, wherein the display module comprises a display and the flexible printed circuit according to any one of claims 1 to 8, and the flexible printed circuit is electrically connected to the display.

10. An electronic device, wherein the electronic device comprises the display module according to claim 9.
